(19) Europäisches Patentamt
European Patent Office
Office européen des brevets

(11) EP 1 091 214 B1

(12) **EUROPÄISCHE PATENTSCHRIFT**

(45) Veröffentlichungstag und Bekanntmachung des Hinweises auf die Patenterteilung:
**21.03.2007 Patentblatt 2007/12**

(51) Int Cl.:
***G01R 19/25*** *(2006.01)*

(21) Anmeldenummer: **00119252.5**

(22) Anmeldetag: **06.09.2000**

(54) **Verfahren und Vorrichtung zur Aufbereitung von Messsignalen**

Method and device for processing measuring signals

Procédé et dispositif de traitement de signaux de mesure

(84) Benannte Vertragsstaaten:
**DE FR GB IT NL**

(30) Priorität: **29.09.1999 DE 19946626**

(43) Veröffentlichungstag der Anmeldung:
**11.04.2001 Patentblatt 2001/15**

(73) Patentinhaber: **Micronas GmbH**
**79108 Freiburg i. Br. (DE)**

(72) Erfinder: **Blossfeld, Lothar**
**78874 Breitnau (DE)**

(74) Vertreter: **Patentanwälte**
**Westphal, Mussgnug & Partner**
**Am Riettor 5**
**78048 Villingen-Schwenningen (DE)**

(56) Entgegenhaltungen:
| | |
|---|---|
| **DE-A- 3 905 735** | **DE-A- 4 336 813** |
| **DE-A- 19 913 753** | **US-A- 5 621 319** |
| **US-A- 5 736 848** | |

EP 1 091 214 B1

**Beschreibung**

Die vorliegende Erfindung betrifft ein Verfahren und eine Vorrichtung zur Aufbereitung eines Meßsignals. Solche Verfahren und Vorrichtungen sind z.B. aus DE 3 905 735 A1 und US 5,736,848 bekannt.

Meßvorrichtungen, wie Sensoren, Brückenschaltungen oder dergleichen, haben den Nachteil, daß sie dem Meßsignal, das für den Benutzer von Interesse ist, ein erstes Offsetsignal überlagern, das bedingt ist durch mechanische Empfindlichkeit der Meßvorrichtung, Ungenauigkeiten in der Herstellungstechnik der Meßvorrichtungen und/oder durch die Elektronik. Der Wert dieses Offsetsignals ist dem Benutzer häufig nicht bekannt und kann darüber hinaus zeitlich variieren.

Einige Meßeinrichtungen wie Hall-Sensoren oder Widerstandsbrückenschaltungen können so angesteuert werden, daß der Offset abwechselnd dem Meßsignal hinzuaddiert und vom Meßsignal subtrahiert wird. Der Offset ist dem Meßsignal damit nicht als Gleichsignal sondern als Wechselsignal, idealerweise als rechteckförmiges Wechselsignal überlagert. Die Ansteuerung der Sensoren bzw. Brückenschaltungen in dieser Weise wird als "Choppern" bezeichnet. Die Frequenz, mit der das Offsetsignal sein Vorzeichen ändert bezeichnet man als "Chopperfrequenz".

Die Chopperfrequenz ist üblicherweise wesentlich höher gewählt als die maximale Frequenz des interessierenden Meßsignals, so daß die Möglichkeit besteht, das hochfrequente Offsetsignal mittels eines Tiefpaßes von dem Meßsignal abzutrennen und dadurch ein offsetfreies Meßsignal zu erhalten.

Nachteilig bei diesem Vorgehen ist der hohe schaltungstechnische Aufwand, den die Filterung des Signals erfordert und die Tatsache, daß durch die Filterung üblicherweise ein neuer Offset erzeugt wird. Die vorliegende Erfindung hat zum Ziel, dies zu vermeiden.

Erreicht wird dieses Ziel durch ein Verfahren mit den Merkmalen des Anspruchs 1 und durch eine Vorrichtung mit den Merkmalen des Anspruchs 7.

Danach wird ein von einer Meßvorrichtung, beispielsweise einem Hall-Sensor oder einer Widerstandsbrücke, geliefertes Summensignal, das sich aus einem Meßsignal und einem Offsetsignal einer ersten Frequenz (Chopperfrequenz) zusammensetzt zur Bereitstellung von Abtastwerten im Takt einer zweiten Frequenz abgetastet, wobei die zweite Frequenz ein Vielfaches der ersten Frequenz ist. Anschließend wird zur Bereitstellung von Meßwerten des Meßsignals der Mittelwert aus wenigstens zwei Abtastwerten gebildet, die durch Abtastungen des Summensignals im Abstand einer halben Periodendauer der ersten Frequenz bzw. im Abstand ungeradzahliger Vielfacher der halben Periodendauer der ersten Frequenz gebildet wurden. Bei der Mittelwertbildung wird immer ein Abtastwert, bei dem der Wert des Offset dem Meßwert hinzuaddiert ist, und immer ein Abtastwert, bei dem der Wert des Offset vom Meßwert subtrahiert ist, berücksichtigt. Der Offset wird durch die Mittelwertbildung dadurch eliminiert.

Davon ausgehend, daß sich das Meßsignal langsam gegenüber der ersten Frequenz des Offsetsignals ändert, hat die Bildung des Mittelwertes zweier Abtastwerte im Abstand der halben Periodendauer des Offsetsignals keinen Einfluß auf den Meßwert. Die durch die Mittelwertbildung hervorgerufene Zeitverzögerung der Meßwerte bzw. die Zeitverzögerung eines aus den Abtastwerten gebildeten aufbereiteten Meßsignals gegenüber dem ursprünglichen Meßsignal kann in der Praxis toleriert werden.

Die Abtastung des Summensignals im Takt der zweiten Frequenz, die ein Vielfaches der ersten Frequenz ist, und die Bereitstellung der Meßwerte durch Mittelwertbildung im Takt der zweiten Frequenz dient einer verbesserten zeitlichen Auflösung des Meßsignals, die insbesondere für die Anwendungen erforderlich ist, in denen der Nulldurchgang des Meßsignals ausgewertet werden soll.

Vorteilhafte Ausgestaltungen der Erfindung sind Gegenstand der Unteransprüche.

Nach einer Ausführungsform der Erfindung ist vorgesehen, das Summensignal aus Meßsignal und Offsetsignal vor der Abtastung zu verstärken. Diese Verstärkung ist erforderlich, wenn die Amplitude des ersten Summensignals, d.h. das Ausgangssignal der Meßvorrichtung, zu klein für eine Weiterbearbeitung durch Abtastung und Mittelwertbildung ist. Nach der Verstärkung des ersten Summensignals, aus der ein zweites Summensignal resultiert, wird das zweite Summensignal abgetastet und der Mittelwert aus wenigstens zwei Abtastwerten gebildet.

Probleme können sich bei der Verwendung von Verstärkern ergeben, die ihrem Eingangssignal, im vorliegenden Fall dem Summensignal aus Meßsignal und dem ersten Offsetsignal einen zweiten Offset hinzufügen.

Es ist deshalb vorgesehen, das Vorzeichen des Eingangssignals des Verstärkers in periodischen Zeitabständen im Takt einer dritten Frequenz zu vertauschen bzw. die Phase des Eingangssignals im Takt der dritten Frequenz um 180° zu drehen. Hierdurch wird bewirkt, daß der zweite Offset des Verstärkers in den Zeitabschnitten, in denen das Vorzeichen des Eingangssignals vertauscht ist, zu dem negativen Eingangssignal hinzuaddiert wird und in den Zeitabschnitte, in denen das Vorzeichen des Eingangssignals beibehalten ist, zu dem positiven Eingangssignal hinzuaddiert wird.

Die Drehung des Vorzeichens des Eingangssignals in periodischen Zeitabständen im Takt der dritten Frequenz wird rückgängig gemacht durch Vertauschen des Vorzeichens des Ausgangssignals in periodischen Zeitabständen im Takt der dritten Frequenz, wobei das Vertauschen des Vorzeichens des Ausgangssignals in Phase mit dem Vertauschen des Vorzeichens des Eingangssignals erfolgt. Hierdurch wird ein Ausgangssignal erhalten, das dem mit einem Verstärkungsfaktor des Verstärkers verstärkten Eingangssignal entspricht, dem der zweite Offset des Verstärkers als rechteckförmiges Signal der dritten Frequenz überlagert ist. Das beschriebene Vorgehen wird als Choppern des Verstärkers mit der dritten Frequenz bezeichnet.

Die dritte Frequenz des Verstärkeroffsetsignals entspricht vorzugsweise der ersten Frequenz des Offsetsignals der Meßanordnung oder ist ein geradzahliges Vielfaches dieser ersten Frequenz. Hierdurch ist gewährleistet, das bei der anschließenden Abtastung und Mittelwertbildung auch der Wert des zweiten Offset des Verstärkers eliminiert wird.

Stimmt die dritte Frequenz, also die Chopperfrequenz des Verstärkers, mit der ersten Frequenz, also der Chopperfrequenz der Meßvorrichtung überein, liegt am Ausgang des Verstärkers ein Signal an, welches dem verstärkten Meßsignal entspricht, dem ein Gesamtoffsetsignal der ersten Frequenz überlagert ist, wobei sich die Amplitude des Gesamtoffsetsignals aus dem verstärkten ersten Offsetsignal der Meßanordnung und dem zweiten Offsetsignal des Verstärkers ergibt. Dieses Gesamtoffsetsignal wird durch die der Abtastung folgende Mittelwertbildung eliminiert.

Die Verstärkung des Verstärkers regelt sich vorzugsweise nach der Amplitude des Eingangssignal, so daß die Amplitude des Ausgangssignals des Verstärkers im wesentlichen unabhängig von der Amplitude des Eingangssignals konstant bleibt.

Die Vorrichtung weist eine Abtastvorrichtung zur Abtastung eines von dem Summensignal abhängigen Eingangssignals im Takt einer zweiten Frequenz zur Bereitstellung einer Folge von Abtastwerten auf. Der Abtastvorrichtung ist eine Vorrichtung zur Mittelwertbildung nachgeschaltet, der die Folge der Abtastwerte zur Bereitstellung von Meßwerten durch Addition bzw. Bildung des Mittelwertes von jeweils zwei Abtastwerten zugeführt sind.

Die Vorrichtung zur Mittelwertbildung weist vorzugsweise einen Speicher zur Abspeicherung von Abtastwerten und einen Addierer zur Addition zweier Speicherwerte oder zur Addition eines Speicherwertes und eines am Eingang der Vorrichtung anliegenden Abtastwertes auf.

Die Anzahl der Speicherzellen des Speichers entspricht vorzugsweise der Anzahl der Abtastwerte, die innerhalb einer halben Periodendauer der ersten Frequenz des ersten Offsetsignals erhalten werden.

Eine weitere Ausführungsform der Erfindung sieht vor, Speicherzellen zur Speicherung der Abtastwerte einer ganzen Periode des Offsetsignals vorzusehen. Zur Mittelwertbildung werden dabei jeweils die Werte zweier Speicherzellen addiert, die im Abstand einer halben Periodendauer des Offsetsignals gewonnen wurden.

Die Erfindung wird nachfolgend in Ausführungsbeispielen anhand von Figuren näher erläutert.

In den Figuren zeigen:

Figur 1:   beispielhafter zeitlicher Verlauf eines Meßsignals, eines Summensignals aus Meßsignal und erstem Offsetsignal und einer gemäß dem erfindungsgemäßen Verfahren erzeugten Folge von Meßwerten;

Figur 2:   erfindungsgemäße Vorrichtung zur Durchführung des erfindungsgemäßen Verfahrens zur Aufbereitung eines Meßsignals ;

Figur 3:   erfindungsgemäße Vorrichtung mit Verstärker;

Figur 4:   schematische Darstellung einer Ausführungsform des Verstärkers;

Figur 5:   beispielhafter zeitlicher Verlauf der Ein- und Ausgangssignale eines Verstärkers nach Figur 4;

Figur 6:   beispielhafter zeitlicher Verlauf eines Meßsignals, eines Summensignals aus Meßsignal und erstem Offsetsignal, eines Verstärkerausgangssignals und einer gemäß dem erfindungsgemäßen Verfahren erzeugten Folge von Meßwerten.

In den Figuren bezeichnen, sofern nicht anders angegeben, gleiche Bezugszeichen gleiche Bauteile, Funktionseinheiten oder Signale mit gleicher Bedeutung.

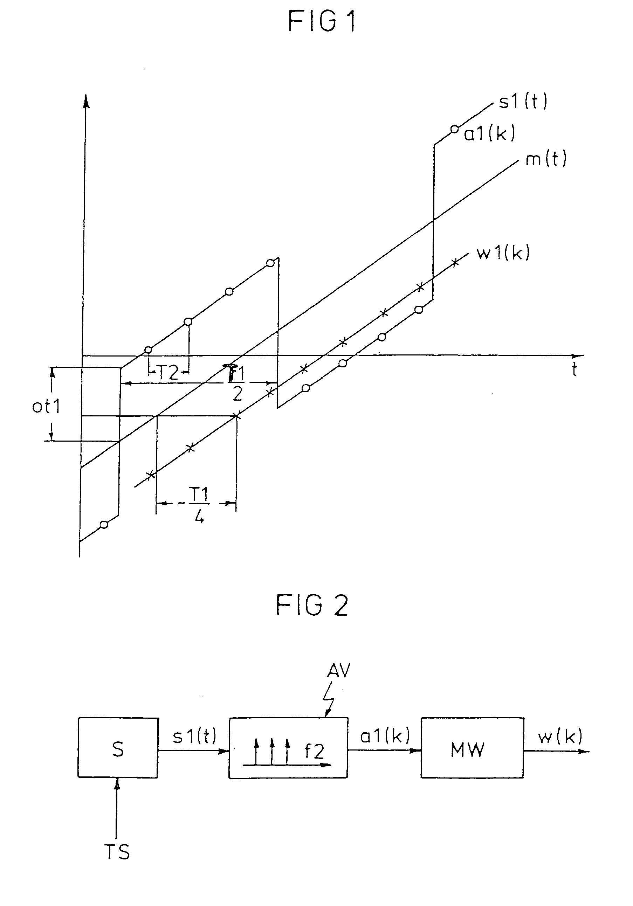

Figur 1 zeigt beispielhaft einen zeitlichen Ausschnitt eines von einer Meßvorrichtung ermittelten Meßsignals (m(t)). Meßvorrichtungen, wie Sensoren, Brückenschaltungen oder dergleichen, die zur Messung derartiger Signale dienen, haben häufig den Nachteil, daß sie dem Meßsignal m(t), das für den Benutzer von Interesse ist, ein erstes Offsetsignal überlagern, das bedingt ist durch mechanische Empfindlichkeit der Meßanordnung, Ungenauigkeiten in der Herstellungstechnik der Meßeinrichtungen und/oder durch die Elektronik. Einige Sensoren, wie beispielsweise Hall-Sensoren oder auch zu Meßzwecken eingesetzte Widerstandsbrücken können so angesteuert werden, daß das im wesentlichen konstante erste Offsetsignal abwechselnd im Takt einer ersten Frequenz f1 dem Meßsignal m(t) hinzuaddiert bzw. von diesem abgezogen wird. Eine derartige Ansteuerung der Meßeinrichtung kann bei Hall-Sensoren beispielsweise durch abwechselnde Stromeinspeisung in den Sensor an verschiedenen Eingängen erfolgen.

Am Ausgang derart angesteuerter Meßvorrichtungen liegt dabei ein erstes Summensignal s1(t) an, welches sich aus der Summe des Meßsignals m(t) und eines Rechtecksignals mit der Amplitude ot1 des ersten Offset und der ersten Frequenz f1 ergibt.

Die erste Frequenz f1, die auch als Chopperfrequenz der Meßvorrichtung bezeichnet wird, ist dabei größer als die maximale Frequenz des Meßsignals m(t). Idealerweise unterscheiden sich die Frequenz des Meßsignals m(t) und die erste Frequenz f1 des Offsetsignals um den Faktor 10 oder mehr. T1 bezeichnet in Figur 1 die Periodendauer des Offsetsignals, wobei T1=1/f1 gilt.

Gemäß dem erfindungsgemäßen Verfahren ist vorgesehen, das erste Summensignal (s1(t)) aus Meßsignal m(t) und rechteckförmigem Offsetsignal in regelmäßigen Zeitabständen T2=1/f2 abzutasten, wobei eine Abtastfrequenz f2 ein ganzzahliges Vielfaches der ersten Frequenz f1 ist. In dem Beispiel in Figur 1 unterscheiden sich die erste Frequenz f1 und die zweite Frequenz f2 um den Faktor acht. Das erste Summensignal s1(t) wird während einer Periode T1 des Offsetsignals achtmal abgetastet. Die durch Abtastung mit der Abtastperiode T2 erhaltenen Abtastwerte sind in Figur 1 durch Kreise dargestellt, die Folge dieser Abtastwerte ist mit a1(k) bezeichnet, wobei

$$a1(k)=s1(t=k \cdot T2)$$

gilt.

Das Verfahren sieht zur Eliminierung des ersten Offset ot1 des weiteren vor, den Mittelwert aus zwei der Abtastwerte a1(k) zu bilden, die im Abstand einer halben Periodendauer T1/2 oder ungeradzahliger Vielfacher der halben Periodendauer T1/2 des Offsetsignals erhalten wurden. Mit w1(k) ist in Figur 1 eine Folge von Mittelwerten bezeichnet, die durch Mittelwertbildung zweier Abtastwerte a1(k) im Abstand einer halben Periodendauer T1/2 erhalten wurden. Es gilt:

$$w(k)=0.5 \cdot [a1(k)+a1(k-T1/(2 \cdot T2))]= 0.5 \cdot [a1(k)+a1(k-n)],$$

wobei n die Anzahl der Abtastwerte bezeichnet, die in der halben Periodendauer T1/2 des ersten Offsetsignals erzeugt wurden.

Davon ausgehend, daß die minimale Periodendauer des Meßsignals m(t) wesentlich größer als die halbe Periodendauer T1/2 ist, um die die Abtastwerte a1(k), a1(k-n) zur Bildung des Mittelwertes zeitlich beabstandet sind, und daß die Steigung des Meßsignals m(t) in diesem Zeitraum T1/2 deshalb als annäherungsweise konstant angenommen werden kann, kann der durch die Mittelwertbildung entstehende Fehler auf den eigentlichen Meßwert des Meßsignals m(t) vernachlässigt werden.

Die Mittelwertbildung resultiert allerdings in einer Zeitverschiebung von etwa T1/4, um die die Folge der Meßwerte w(k) gegenüber dem Meßsignal m(t) verschoben ist. Diese konstante Zeitverschiebung kann bei der späteren Auswertung der Meßwerte berücksichtigt werden und ist daher für die meisten Anwendungen unkritisch.

Je größer die Abtastfrequenz f2 gewählt wird, je mehr Meßwerte w1(k) pro Zeiteinheit durch Abtastung und Mittelwertbildung also erzeugt werden, um so größer ist die Zeitauflösung, die mit dem erfindungsgemäßen Verfahren erreicht werden kann. Für viele Anwendungen ist insbesondere von Interesse, wann das Meßsignal m(t) bzw. wann die Folge der Meßwerte w1(k), von der -unter Berücksichtigung der durch die Mittelwertbildung eingefügten Zeitverschiebung- auf das Meßsignal m(t) geschlossen werden kann, durch Null geht. Der Zeitpunkt des Nulldurchgangs wird dabei durch die beiden Meßwerte der Meßwertfolge w(k) eingegrenzt, zwischen denen ein Wechsel des Vorzeichens stattgefunden hat. Die maximale zeitliche Unsicherheit beträgt dabei 1/T2 und nimmt mit steigender Abtastfrequenz f2 ab.

In Figur 2 ist schematisch eine erfindungsgemäße Vorrichtung zur Durchführung des erfindungsgemäßen Verfahrens für die Aufbereitung eines Meßsignals m(t) dargestellt. Die Vorrichtung weist eine Meßvorrichtung S auf, mit einer Ausgangsklemme, an der ein erstes Summensignal s1(t) zur Verfügung steht, welches aus der Überlagerung eines Meßsignals m(t) und eines wenigstens annäherungsweise rechteckförmigen Offsetsignals mit einer ersten Frequenz f1 und einer Amplitude ot1 besteht. Dem Sensor ist ein Taktsignal TS der ersten Frequenz f1 zugeführt, nach dessen Maßgabe die Meßanordnung S "gechoppert" wird, um dem Meßsignal m(t) ein Offsetsignal der ersten Frequenz f1 anstelle eines Gleichsignals zu überlagern.

Der Meßanordnung ist eine Abtastvorrichtung AV nachgeschaltet, der das erste Summensignal s1(t) zugeführt ist und die dazu dient, das erste Summensignal s1(t) in Zeitabständen der Periode T2=1/f2 abzutasten. An einem Ausgang der Abtastvorrichtung AV liegen in dem durch die Abtastung vorgegebenen Zeittakt T2 die Abtastwerte a1(k) des Summensignals s1(t)an.

Die Folge der Abtastwerte a1(k) ist einer Vorrichtung MW zur Mittelwertbildung zugeführt, in der von jeweils zwei Abtastwerten a1(k), a1(k-n), die durch Abtastung im zeitlichen Abstand einer halben Periodendauer T1/2 des Offsetsignals oder im Abstand eines ungeradzahligen Vielfachen der halben Periodendauer T1/2 des Offsetsignals gewonnen wurden, der Mittelwert gebildet wird.

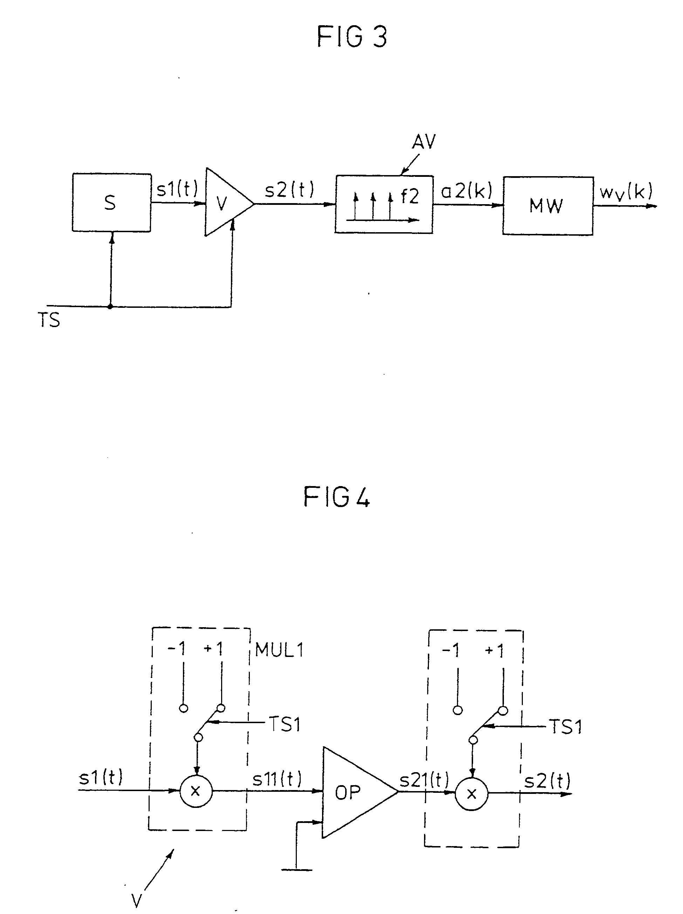

Vielfach ist die Amplitude des Summensignals s1(t) zu klein, um es durch Abtastung weiterbearbeiten zu können. Vorzugsweise ist der Meßanordnung daher ein Verstärker V nachgeschaltet, wie in Figur 3 dargestellt ist. Am Ausgang des Verstärkers V liegt ein zweites Summensignal s2(t), welches in der Abtastvorrichtung AV mit der Taktperiode T2 zur Bildung einer Folge von Abtastwerten a2(k) abgetastet wird. Die Folge a2(k) ist der Vorrichtung MW zur Bereitstellung einer Folge von Meßwerte w2(k) durch Bildung des Mittelwertes aus zwei Abtastwerten a2(k), a2(k-n) zugeführt.

Die Verstärkung des Summensignals s1(t) mittels üblicher Verstärker, wie Operationsverstärker bringt den Nachteil mit sich, daß dem Summensignal s1(t) unvermeidlich ein zweiter Offset durch den Verstärker hinzugefügt wird.

Die Ausführungsform eines Verstärkers V, die die nachteilige Wirkung eines zweiten Offset im Ergebnis vermeidet, ist in Figur 4 dargestellt.

Der Verstärker weist ein Verstärkungsglied OP, beispielsweise einen Operationsverstärker, auf, der ein ihm zugefügtes Signal s11(t) mit einem Faktor v verstärkt und dem verstärkten Signal dabei einen zweiten Offset ot2 hinzufügt. Dem Verstärkungsglied OP ist eine erste Multiplizieranordnung MUL1 vorgeschaltet, der das Eingangssignal des Verstärkers V, in dem Beispiel das erste Summensignal s1(t) zugeführt ist, wobei dieses Signal s1(t) nach Maßgabe eines Taktsignals TS1 mit dem Faktor "+1" oder "-1" multipliziert wird, um die Phase des Signals nach Maßgabe des Taktsignals TS1 um 180° zu drehen. Die Phasenverschiebung des Eingangssignals s1(t) wird durch eine dem Verstärkungsglied OP nachgeschaltete zweite Multiplizieranordnung MUL2 rückgängig gemacht, in der das Ausgangssignal s21(t) des Verstärkungsglieds OP nach Maßgabe des Taktsignals TS2 mit dem Faktor "+1" bzw. "-1" multipliziert wird. Die Multiplizieranordnungen MUL1, MUL2 weisen einen im Takt des Taktsignals TS2 umschaltbaren Schalter auf, der an einen Eingang eines Multiplizierers abwechselnd den Wert "+1" oder "-1" anlegt, wobei an einem zweiten Eingang des Multiplizierers das zu multiplizierende Signal s11(t); s21(t) anliegt.

Die Umschaltung der Schalter bzw. die Phasenverschiebung des Eingangssignals s1(t) und des Ausgangssignals s21(t) erfolgt vorzugsweise im Takt der ersten Frequenz f1 oder im Takt geradzahliger Vielfacher der ersten Frequenz.

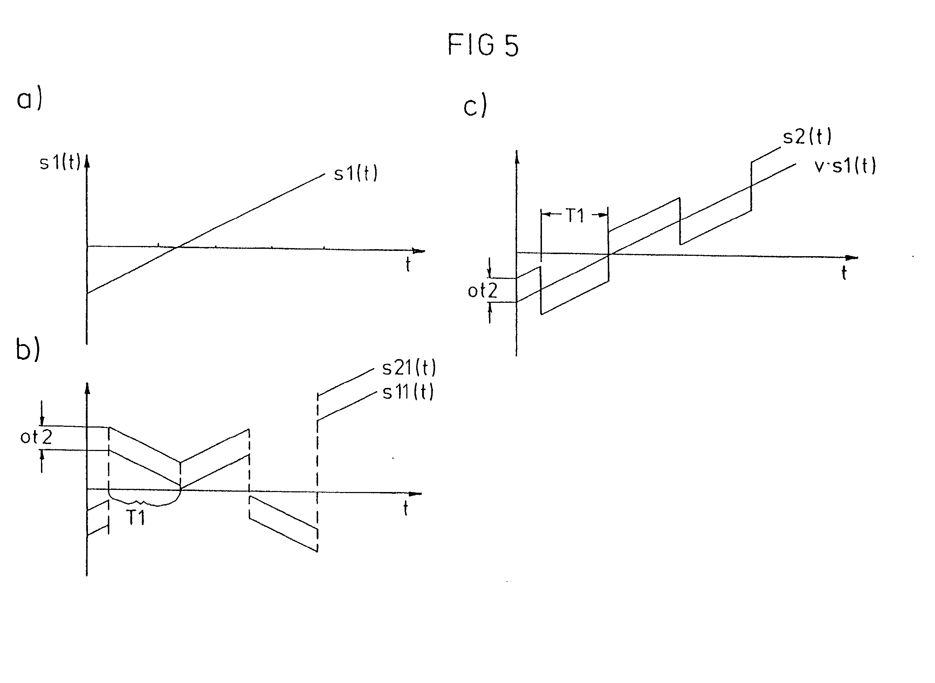

Die Funktionsweise des Verstärkers V ist anhand ausgewählter Signalverläufe in Figur 5 dargestellt. Figur 1a zeigt beispielhaft den Signalverlauf eines Eingangssignals s1(t) des Verstärkers V. Am Ausgang des ersten Multiplizierers MUL1 liegt ein in Figur 5b dargestelltes Signal s11(t) an, welches abschnittsweise aufgrund der Multiplikation mit "1" mit dem Eingangssignal s1(t) übereinstimmt und in den anderen Abschnitten aufgrund der Multiplikation mit "-1" an der Zeitachse gespiegelt zu dem Eingangssignal s1(t) ist. Das Verstärkungsglied OP verstärkt das an seinem Eingang anliegende Signal s11(t) mit einem Verstärkungsfaktor v und fügt ihm einen Offset einer Amplitude ot2 hinzu, woraus das in Figur 5b eingezeichnete Signal s21(t) resultiert. Aus Gründen der Übersichtlichkeit wurde als Verstärkungsfaktor v in dem Beispiel nach Figur 5 eins gewählt. Übliche Werte für Verstärkungsfaktoren liegen über 100. Ein derart verstärktes Signal wäre in Figur 5b entsprechend nach oben verschoben.

Nach dem Rückgängigmachen der Phasendrehung des Signals s1(t) durch entsprechende Phasendrehung des Signals s21(t) ergibt sich das Ausgangssignal s2(t), welches sich als verstärktes Eingangssignals v·s1(t) darstellt, dem ein rechteckförmiges Offsetsignal einer Amplitude ot2 überlagert ist.

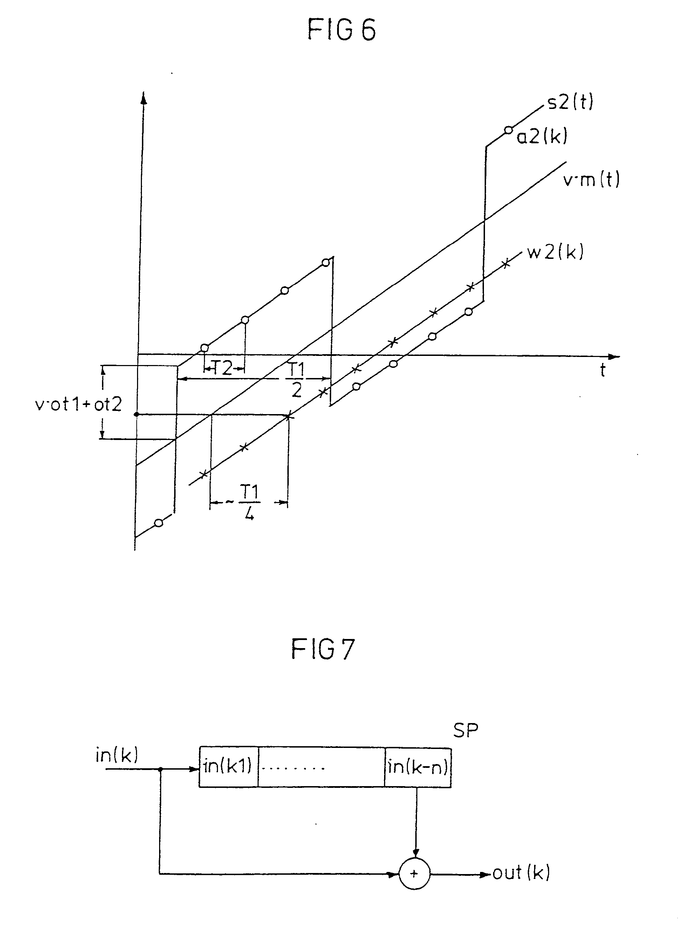

Wird als Eingangssignal s1(t) des Verstärkers v ein Ausgangssignal der Meßvorrichtung S gewählt, bei dem einem Meßsignal m(t) durch Choppern der Meßanordnung S ein Offsetsignal der ersten Frequenz f1 überlagert ist, und erfolgt die Phasendrehung des Signals s1(t) bzw. S21(t) im Takt der ersten Frequenz f1 und in Phase zu dem ersten Offsetsignal, dann liegt als Ausgangssignal s2(t) des Verstärkers V das verstärkte Meßsignal v·m(t) an, dem ein Offsetsignal der Frequenz f1 und der Amplitude v·ot1+ot2 überlagert ist, wie in Figur 6 dargestellt ist.

Die Weiterbearbeitung dieses Signals s2(t) entspricht der des unverstärkten Signals s1(t), die anhand der Figuren 1 und 2 erläutert wurde. Das Signal s2(t) wird im Takt der zweiten Frequenz f2 zur Bereitstellung einer Folge von Abtastwerten s2(k) abgetastet. Die Bildung des Mittelwertes aus jeweils zwei Abtastwerten die im Abstand einer halben Periodendauer T1/2 des Offsetsignals durch die Abtastung erhalten wurden, ergibt eine Folge von Meßwerten w2(k) im Takt der Abtastfrequenz f2, die Meßwerten des Meßsignals m(t) entsprechen, die um einen Faktor v verstärkt sind, wobei die Werte w2(k) etwa um T1/4 zeitlich gegenüber den tatsächlichen Meßwerten verschoben sind.

Wird der Verstärker mit einer dritten Frequenz gechoppert, die ein geradzahliges Vielfaches der ersten Frequenz f1 ist, wird durch die anschließende Abtastung und Mittelwertbildung der durch das Verstärkungsglied OP eingefügte zweite Offset ot2 ebenfalls eliminiert. Das Choppern des Verstärkers muß nicht in Phase mit dem ersten Offsetsignal erfolgen.

Vielfach weisen Verstärkungsglieder, wie Operationsverstärker, einen invertierenden und einen nicht invertierenden Eingang sowie einen invertierenden und einen nicht invertierenden Ausgang auf. Das Choppern des Verstärkers kann bei diesen Verstärkern dadurch erfolgen, daß das Eingangssignal nach Maßgabe eines Taktsignals abwechselnd an den invertierenden und nicht invertierenden Eingang angelegt wird und daß das Ausgangssignal nach Maßgabe desselben Taktsignals abwechselnd an dem invertierenden und nicht invertierenden Ausgang abgegriffen wird.

Eine Vorrichtung MW zur Mittelwertbildung ist in Figur 7 dargestellt. Die Vorrichtung weist eine Speichervorrichtung SP, vorzugsweise ein Schieberegister auf, in welchem eine Anzahl Abtastwerte der Folge der Abtastwerte a1(k), a2(k) gespeichert werden können. Die Anzahl der Speicherzellen entspricht vorzugsweise der Anzahl n der Abtastwerte, die in dem Zeitintervall T1/2 erzeugt werden, welches zwischen den Abtastwerten a1(k), a1(k-n); a2(k), a2(k-n) liegt, die zur Mittelwertbildung herangezogen werden. Die Vorrichtung weist des weiteren einen Addierer auf, der den aktuellen Abtastwert a1(k); a2(k) und den früher erzeugten abgespeicherten Abtastwert a1(k-n); a2(k-n) addiert. Das Ausgangssignal des Addierers wird zur korrekten Mittelwertbildung mit dem Faktor 1/2 multipliziert. Da vielfach ohnehin eine Verstärkung der Meßwerte gewünscht ist, kann auf diese Multiplikation mit 1/2 auch verzichtet werden.

**Patentansprüche**

1. Verfahren zur Aufbereitung eines eine Messsignalfrequenz aufweisenden Messsignals (m(t)), dem ein erstes Offsetsignal einer ersten Frequenz (f1), welche größer als die Messsignalfrequenz ist, überlagert ist, wobei das Verfahren folgende Verfahrensschritte aufweist:

   - Abtasten eines von der Summe aus dem Messsignal m(t) und dem ersten Offsetsignal abhängigen Summensignals (s1(t); s2(t)) im Takt einer zweiten Frequenz (f2), die ein ganzzahliges Vielfaches größer als die erste Frequenz (f1) ist, zur Bereitstellung einer Folge von Abtastwerten (a1(k); a2(k));
   - Bereitstellen von Messwerten (w1(k); w2(k)) des Messsignals (m(t)) durch Addition von zwei Abtastwerten (a1(k), a1(k-n); a2(k), a2(k-n)), die im zeitlichen Abstand der halben Periodendauer (T1/2) oder ungeradzahliger Vielfacher der halben Periodendauer (T1/2) des Offsetsignals gewonnen werden.

2. Verfahren nach Anspruch 1,
   **dadurch gekennzeichnet, dass** ein erstes Summensignal (s1(t)) aus dem Messsignal (m(t)) und dem ersten Offsetsignal vor der Abtastung zur Bereitstellung eines zweiten Summensignals (s2(t)) verstärkt wird.

3. Verfahren nach einem der vorangehenden Ansprüche,
   **dadurch gekennzeichnet, dass** die Verstärkung des ersten Summensignals (s1(t)) folgende Verfahrensschritte aufweist:

   - Drehen der Phase des ersten Summensignals (s1(t)) in periodischen, durch eine dritte Frequenz vorgegebenen Zeitabständen um 180° zur Bereitstellung eines Signals s11(t);
   - Verstärken des Signals s11(t) um einen Verstärkungsfaktor (v) zur Bereitstellung eines verstärkten Signals (s21(t));
   - Drehen der Phase des verstärkten Signals (s21(t)) in periodischen, durch die dritte Frequenz vorgegebenen Zeitabständen um 180°.

4. Verfahren nach Anspruch 3,
   **dadurch gekennzeichnet, dass** die dritte Frequenz gleich der ersten Frequenz oder ein geradzahliges Vielfaches der ersten Frequenz (f1) ist.

5. Verfahren nach Anspruch 3 oder 4,
   **dadurch gekennzeichnet, dass** die Phasendrehung des ersten Summensignals (s1(t)) in Phase zu dem ersten Offsetsignal erfolgt.

6. Verfahren nach einem der vorangehenden Ansprüche,
   **dadurch gekennzeichnet, dass** die Verstärkung des Summensignals (s2(t)) abhängig von der Amplitude des Messsignals (m(t)) erfolgt.

7. Vorrichtung zur Aufbereitung eines eine Messfrequenz aufweisenden Messsignals (m(t)), dem ein Offsetsignal einer ersten Frequenz (f1), welche größer als die Messfrequenz ist, überlagert ist, wobei die Vorrichtung folgende Merkmale aufweist:

   - eine Abtastvorrichtung (AV) zur Abtastung eines von der Summe des Messsignals (m(t)) und des Offsetsignals abhängigen Summensignals (s1(t); s2(t)) im Takt einer zweiten Frequenz (f2), die ein ganzzahliges Vielfaches größer als die erste Frequenz (f1) ist, und zur Bereitstellung einer Folge von Abtastsignalen (a1(k)); a2(k));
   - eine der Abtastvorrichtung (AV) nachgeschaltete Vorrichtung (MW) zur Mittelwertbildung, der die Folge der Abtastwerte (a1(k); a2(k)) zugeführt ist, mittels Bereitstellung von Messwerten (w1(k)); w2(k)) des Messsignals (m(t)) durch Addition von zwei Abtastwerten (a1(k), a1(k-n); a2(k), a2(k-n)), die im zeitlichen Abstand der halben Periodendauer (T1/2) oder ungeradzahliger Vielfacher der halben Periodendauer (T1/2) des Offsetsignals gewonnen werden.

**8.** Vorrichtung nach Anspruch 7,
**dadurch gekennzeichnet, dass** der Abtastvorrichtung (AV) ein Verstärker (V) zur Bereitstellung eines zweiten Summensignals (s2(t)) durch Verstärkung eines ersten Summensignals (s1(t)) aus dem Messsignal (m(t)) und dem Offsetsignal vorgeschaltet ist.

**9.** Vorrichtung nach Anspruch 8,
**dadurch gekennzeichnet, dass** der Verstärker (V) folgende Merkmale aufweist:

- eine erste Multiplizieranordnung (MUL1) zur Multiplikation eines Verstärkereingangsignals (s1(t)) mit einem Faktor "-1" im Takt einer dritten Frequenz (f3) und zur Bereitstellung eines Multiplikationssignals (s11(t)) ;
- ein Verstärkungsglied (OP) zur Verstärkung des Multiplikationssignals (s11(t));
- eine zweite Multiplizieranordnung (MUL1) zur Multiplikation eines Ausgangssignals (s21(t)) des Verstärkungsglieds (OP) mit einem Faktor "-1" im Takt der dritten Frequenz (f3).

**10.** Vorrichtung nach einem der Ansprüche 7 bis 9,
**dadurch gekennzeichnet, dass** die Vorrichtung (MW) zur Mittelwertbildung einen Speicher (SP) zur Speicherung von Abtastwerten (a1(k-1),..., a1(k-n); a2(k-1),..., a2 (k-n)) und einen Addierer (ADD) zur Addition eines abgespeicherten Abtastwertes (a1(k-n); a2(k-n)) und eines am Ausgang der Abtastvorrichtung (AV) anliegenden Abtastwertes (a1(k); a2(k)) aufweist.

**11.** Vorrichtung nach einem der Ansprüche 7 bis 10,
**dadurch gekennzeichnet, dass** in dem Speicher (SP) so viele Abtastwerte (a1(k-1),...,a1 (k-n); a2(k-1),..., a2(k-n)) abspeicherbar sind, wie in einer halben Periodendauer (T1/2) des Offsetsignals durch Abtastung erzeugt werden.

**Claims**

**1.** Method for processing a measured signal (m(t)) having a measured signal frequency, which is superposed with a first offset signal of a first frequency (f1) which is greater than the measured signal frequency, wherein the method comprises the following method steps:

- sampling a sum signal (s1(t) ; s2(t)), which depends on the sum of the measured signal m(t) and the first offset signal, in step with a second frequency (f2) which is a whole-number multiple greater than the first frequency (f1), in order to provide a sequence of sampled values (a1(k); a2(k));
- providing measured values (w1(k); w2(k)) of the measured signal (m(t)) by adding two sampled values (a1(k), a1(k-n); a2(k), a2(k-n)) obtained at the time interval of the half-period duration (T1/2) or an odd multiple of the half-period duration (T1/2) of the offset signal.

**2.** Method according to claim 1, **characterised in that** a first sum signal (s1(t)) obtained from the measured signal (m(t)) and the first offset signal is amplified prior to sampling in order to provide a second sum signal (s2(t)).

**3.** Method according to one of the preceding claims, **characterised in that** the amplification of the first sum signal (s1(t)) comprises the following method steps:

- shifting the phase of the first sum signal (s1(t)) by 180° at periodic time intervals defined by a third frequency, in order to provide a signal s11(t);
- amplifying the signal s11(t) by an amplification factor (v) in order to provide an amplified signal (s21(t));
- shifting the phase of the amplified signal (s21(t)) by 180° at periodic time intervals defined by the third frequency.

**4.** Method according to claim 3, **characterised in that** the third frequency is identical to the first frequency or is an even multiple of the first frequency (f1).

**5.** Method according to claim 3 or 4, **characterised in that** the phase shift of the first sum signal (s1t)) takes place in phase with the first offset signal.

6. Method according to one of the preceding claims, **characterised in that** the amplification of the sum signal (s2(t)) takes place in a manner dependent on the amplitude of the measured signal (m(t)).

7. Device for processing a measured signal (m(t)) having a measured frequency, which is superposed with an offset signal of a first frequency (f1) which is greater than the measured frequency, wherein the device comprises the following features:

   - a sampling device (AV) for sampling a sum signal (s1(t); s2(t)), which depends on the sum of the measured signal (m(t)) and the offset signal, in step with a second frequency (f2) which is a whole-number multiple greater than the first frequency (f1), in order to provide a sequence of sampled values (a1(k); a2(k));
   - a device (MW) for averaging downstream of the sampling device (AV), to which device (MW) the sequence of sampled values (a1(k); a2(k)) is fed, by providing measured values (w1(k); w2(k)) of the measured signal (m(t)) by adding two sampled values (a1(k), a1(k-n); a2(k), a2(k-n)) obtained at the time interval of the half-period duration (T1/2) or an odd multiple of the half-period duration (T1/2) of the offset signal.

8. Device according to claim 7, **characterised in that** connected upstream of the sampling device (AV) is an amplifier (V) for providing a second sum signal (s2(t)) by amplifying a first sum signal (s1(t)) obtained from the measured signal (m(t)) and the offset signal.

9. Device according to claim 8, **characterised in that** the amplifier (V) comprises the following features:

   - a first multiplier arrangement (MUL1) for multiplying an amplifier input signal (s1(t)) by a factor "-1" in step with a third frequency (f3) and for providing a multiplication signal (s11(t));
   - an amplification element (OP) for amplifying the multiplication signal (s11(t));
   - a second multiplier arrangement (MUL1) for multiplying an output signal (s21(t)) of the amplification element (OP) by a factor "-1" in step with the third frequency (f3).

10. Device according to one of claims 7 to 9, **characterised in that** the device (MW) for averaging comprises a memory (SP) for storing sampled values (a1(k-1), ..., a1(k-n); a2(k-1), ..., a2(k-n)) and an adder (ADD) for adding a stored sampled value (al(k-n); a2(k-n)) and a sampled value (a1 (k); a2(k)) present at the output of the sampling device (AV).

11. Device according to one of claims 7 to 10, **characterised in that** the memory (SP) is able to store as many sampled values (a1(k-1), ..., a1(k-n); a2(k-1), ..., a2(k-n)) as are produced by sampling in a half-period duration (T1/2) of the offset signal.

**Revendications**

1. Procédé de traitement d'un signal de mesure (m(t)) présentant une fréquence de signal de mesure, auquel est superposé un premier signal de décalage d'une première fréquence (f1) supérieure à la fréquence du signal de mesure, le procédé présentant les étapes de procédé suivantes :

   - balayage d'un signal composite (s1(t) ; s2(t)) dépendant de la somme du signal de mesure m(t) et du premier signal de décalage dans le rythme d'horloge d'une deuxième fréquence (f2) qui est supérieure d'un multiple pair à la première fréquence (f1), pour la mise à disposition d'une séquence de valeurs de balayage (a1(k) ; a2(k)) ;
   - mise à disposition de valeurs de mesure (w1(k) ; w2(k)) du signal de mesure (m(t)) par l'addition de deux valeurs de balayage (a1(k), a1(k-n) ; a2(k), a2(k-n)) collectées à intervalles d'une demi-période (T1/2) ou d'un multiple impair de la demi-période (T1/2) du signal de décalage.

2. Procédé selon la revendication 1,
   **caractérisé en ce qu'**
   un premier signal composite (s1(t)) constitué du signal de mesure (m(t)) et du premier signal de décalage est amplifié avant le balayage pour la mise à disposition d'un deuxième signal composite (s2(t)).

3. Procédé selon l'une des revendications précédentes,
   **caractérisé en ce que**
   l'amplification du premier signal composite (s1(t)) présente les étapes de procédé suivantes :

- rotation de 180° de la phase du premier signal composite (s1(t)) à intervalles périodiques prédéterminés par une troisième fréquence, pour la mise à disposition d'un signal s 11(t) ;
- amplification du signal s11(t) d'un facteur d'amplification (v) pour la mise à disposition d'un signal amplifié (s21(t)) ;
- rotation de 180° de la phase du signal amplifié (s21(t)) à intervalles périodiques prédéterminés par la troisième fréquence.

4. Procédé selon la revendication 3,
**caractérisé en ce que**
la troisième fréquence est égale à la première fréquence ou à un multiple pair de la première fréquence (f1).

5. Procédé selon la revendication 3 ou 4,
**caractérisé en ce que**
la rotation de phase du premier signal composite (s1(t)) s'effectue en phase avec le premier signal de décalage.

6. Procédé selon l'une des revendications précédentes,
**caractérisé en ce que**
l'amplification du signal composite (s2(t)), s'effectue en fonction de l'amplitude du signal de mesure (m(t)).

7. Dispositif de traitement d'un signal de mesure (m(t)) présentant une fréquence de mesure, auquel est superposé un signal de décalage d'une première fréquence (f1) supérieure à la fréquence de mesure, le dispositif présentant les caractéristiques suivantes :

- un dispositif de balayage (AV) pour le balayage d'un signal composite (s1(t); s2(t)) dépendant de la somme du signal de mesure (m(t)) et du signal de décalage dans le rythme d'horloge d'une deuxième fréquence (f2), qui est un multiple pair supérieur à la première fréquence (f1), et pour mettre à disposition une séquence de signaux de balayage (a1(k) ; a2(k)) ;
- un dispositif (MW) disposé en aval du dispositif de balayage (AV) pour la formation de la valeur moyenne, qui reçoit la séquence de valeurs de balayage (al (k) ; a2(k)), au moyen de la mise à disposition de valeurs de mesure (w1(k); w2(k)) du signal de mesure (m(t)) par l'addition de deux valeurs de balayage (a1(k), a1(k-n) ; a2(k), a2(k-n)) collectées à intervalles de la demi-période (T1/2) ou d'un multiple impair de la demi-période (T1/2) du signal de décalage.

8. Dispositif selon la revendication 7,
**caractérisé en ce qu'**
en amont du dispositif de balayage (AV) est disposé un amplificateur (V) pour la mise à disposition d'un deuxième signal composite (s2(t)) par l'amplification d'un premier signal composite (s1(t)) constitué du signal de mesure (m (t)) et du signal de décalage.

9. Dispositif selon la revendication 8,
**caractérisé en ce que**
l'amplificateur (V) présente les caractéristiques suivantes :

- un premier dispositif de multiplication (MUL1) pour la multiplication d'un signal d'entrée d'amplificateur (s1(t)) par un facteur « -1 » dans le rythme d'horloge d'une troisième fréquence (f3) et pour la mise à disposition d'un signal de multiplication (s11(t));
- un élément d'amplification (OP) pour l'amplification du signal de multiplication (s11(t)) ;
- un deuxième dispositif de multiplication (MUL1) pour la multiplication d'un signal de sortie (s21(t)) de l'élément d'amplification (OP) par un facteur « -1 » dans le rythme d'horloge de la troisième fréquence (f3).

10. Dispositif selon l'une des revendications 7 à 9,
**caractérisé en ce que**
le dispositif (MW) de formation de valeur moyenne présente une mémoire (SP) pour l'enregistrement de valeurs de balayage (a1(k-1), ..., a1(k-n) ; a2(k-1),..., a2(k-n)) et un dispositif d'addition (ADD) pour l'addition d'une valeur de balayage enregistrée (a1(k-n) ; a2(k-n)) et d'une valeur de balayage (a1(k) ; a2(k)) appliquée à la sortie du dispositif de balayage (AV).

11. Dispositif selon l'une des revendications 7 à 10,

**caractérisé en ce que**

dans la mémoire (SP) peuvent être enregistrées autant de valeurs de balayage (a1(k-1),..., a1(k-n) ; a2(k-1),..., a2(k-n)) que générées par balayage dans une demi-période (T1/2) du signal de décalage.

## FIG 1

## FIG 2

# FIG 3

# FIG 4

# FIG 5

a)

b)

c)

EP 1 091 214 B1

## FIG 6

## FIG 7